(19) Europäisches Patentamt
European Patent Office
Office européen des brevets

(11) **EP 3 950 643 B1**

(12) **EUROPEAN PATENT SPECIFICATION**

(45) Date of publication and mention
of the grant of the patent:
**28.06.2023 Bulletin 2023/26**

(51) International Patent Classification (IPC):
**C04B 38/00** (2006.01)   **C04B 41/83** (2006.01)
**C04B 35/583** (2006.01)   **C04B 35/626** (2006.01)
**H01L 23/373** (2006.01)   **H05K 1/03** (2006.01)

(21) Application number: **20783991.1**

(22) Date of filing: **26.03.2020**

(52) Cooperative Patent Classification (CPC):
(C-Sets available)
**C04B 41/83; C04B 35/583; C04B 35/62615;
C04B 35/6263; C04B 35/62635; C04B 35/6264;
C04B 35/62655; C04B 38/00; C04B 38/0054;
C04B 41/009; C04B 41/4853; H01L 23/3731;
H01L 23/3733; H05K 1/0313; H05K 1/0373;**

(Cont.)

(86) International application number:
**PCT/JP2020/013804**

(87) International publication number:
**WO 2020/203688 (08.10.2020 Gazette 2020/41)**

(54) **METHOD FOR PRODUCING COMPOSITE BODY**

VERFAHREN ZUR HERSTELLUNG EINES VERBUNDKÖRPERS

PROCÉDÉ DE FABRICATION DE COMPOSITE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.03.2019 JP 2019067120**

(43) Date of publication of application:
**09.02.2022 Bulletin 2022/06**

(73) Proprietor: **Denka Company Limited
Tokyo 103-8338 (JP)**

(72) Inventors:
• **INOUE Saori**
**Tokyo 103-8338 (JP)**
• **IWAKIRI Shoji**
**Tokyo 103-8338 (JP)**
• **MINAKATA Yoshitaka**
**Tokyo 103-8338 (JP)**
• **YOSHIMATSU Ryo**
**Tokyo 103-8338 (JP)**
• **KOGA Ryuji**
**Tokyo 103-8338 (JP)**
• **YAMAGUCHI Tomoya**
**Tokyo 103-8338 (JP)**

(74) Representative: **Hoffmann Eitle
Patent- und Rechtsanwälte PartmbB
Arabellastraße 30
81925 München (DE)**

(56) References cited:
**WO-A1-2017/155110     JP-A- H08 244 163
JP-A- 2015 124 122**

(52) Cooperative Patent Classification (CPC): (Cont.)
C04B 2111/00844; C04B 2235/3208;
C04B 2235/3409; C04B 2235/386;
C04B 2235/3895; C04B 2235/528;
C04B 2235/5436; C04B 2235/616;
C04B 2235/6567; C04B 2235/658;
C04B 2235/6586; C04B 2235/767;
H05K 2201/0154; H05K 2201/0209

C-Sets
**C04B 38/00, C04B 35/583, C04B 38/0054,
C04B 38/0074;**

**C04B 38/0054, C04B 35/583;
C04B 41/009, C04B 35/583, C04B 38/00;
C04B 41/4853, C04B 41/4515, C04B 41/4521**

## Description

### Technical Field

The present invention relates to a method for producing a composite.

### Background Art

In an electronic component such as a power device, a transistor, a thyristor, or a CPU, efficient dissipation of heat generated during use is a problem. In order to solve this problem, conventionally, an insulating layer of a printed wiring board on which an electronic component is mounted is made to have high thermal conductivity, and the electronic component or the printed wiring board is attached to a heat sink via an electrically insulating thermal interface material. As the insulating layer and the thermal interface material, a composite (heat dissipation member) composed of resin and ceramics such as boron nitride is used.

As such a composite, a composite in which a ceramic powder is dispersed in a resin has been conventionally used, but in recent years, a composite in which a porous ceramic sintered body (for example, a boron nitride sintered body) is impregnated with a resin has also been studied (for example, Patent Document 1).

Patent Documents 2 and 3 disclose a method for impregnating a porous boron nitride with a resin.

### Citation List

### Patent Document

[Patent Document 1] International publication WO 2014/196496
[Patent Document 2] JP 2015 124122 A
[Patent Document 3] WO 2014/196496 A1

### Summary of Invention

### Technical Problem

According to studies conducted by the inventors of the present invention, a composite in which a porous boron nitride sintered body is impregnated with a resin as described above has room for further improvement in terms of insulating property capable of withstanding a high voltage.

Accordingly, an object of the present invention is to provide a method for producing a composite having excellent insulation properties.

### Solution to Problem

One aspect of the present invention is a method for producing a composite, including a step of placing a porous boron nitride sintered body immersed in a resin composition under a pressurized condition and then placing the boron nitride sintered body immersed in the resin composition under a pressure condition lower than the pressurized condition, wherein the step is repeated a plurality of times.

The method may further include, before the step, a step of placing the boron nitride sintered body immersed in the resin composition under a reduced pressure condition and then placing the boron nitride sintered body immersed in the resin composition under a pressure condition higher than the reduced pressure condition.

The the boron nitride sintered body may have an average pore diameter of 3.5 $\mu$m or less.

### Advantageous Effects of Invention

According to the present invention, a method for producing a composite having excellent insulation properties can be provided.

### Description of Embodiments

Embodiments of the present invention will now be described in detail.

One embodiment of the present invention is a method for producing a composite including a porous boron nitride sintered body and a resin filled in the pores of the boron nitride sintered body.

In this production method, first, a boron nitride sintered body is impregnated with a resin composition (impregnation step). In one embodiment, the impregnation step includes a step S1 of preparing a boron nitride sintered body and a resin composition, a step S2 of placing the boron nitride sintered body immersed in the resin composition under a reduced pressure condition and then placing the boron nitride sintered body immersed in the resin composition under a pressure condition higher than the reduced pressure condition, and a step S3 of placing the boron nitride sintered body immersed in the resin composition under a pressurized condition.

In step S1, the boron nitride sintered body and the resin composition are each provided in, for example, an impregnation apparatus with controllable pressure.

The boron nitride sintered body is formed by sintering primary particles of boron nitride together. The boron nitride sintered body is a porous sintered body having a plurality of pores. The average pore diameter of the boron nitride sintered body may be, for example, 0.1 $\mu$m or more, and is preferably 0.5 $\mu$m or more, more preferably 0.8 $\mu$m or more, and still more preferably 1 $\mu$m or more, from the viewpoint of being able to suitably fill the pores with the resin composition. The average pore diameter of the boron nitride sintered body may be, for example, 5 $\mu$m or less or 4 $\mu$m or less, and is preferably 3.5 $\mu$m or less, more preferably 3 $\mu$m or less, still more preferably 2 $\mu$m or less, and particularly preferably 1.5 $\mu$m or less, from the viewpoint of obtaining a composite having more excellent insulation properties (more remarkably obtaining the effect of improving insulation properties by repeating step S3 described later).

The average pore diameter of the boron nitride sintered body is defined as the pore diameter at which the cumulative pore volume reaches 50% of the total pore volume in the pore diameter distribution (horizontal axis: pore diameter, vertical axis: cumulative pore volume) measured using a mercury porosimeter. As the mercury porosimeter, for example, a mercury porosimeter manufactured by Shimadzu Corporation can be used, and the measurement can be performed while increasing the pressure from 0.03 atm to 4000 atm.

The proportion of pores (porosity) in the boron nitride sintered body is preferably 10% by volume or more based on the total volume of the boron nitride sintered body from the viewpoint of suitably improving the strength of the composite by filling the resin, and is preferably 70% by volume or less, and more preferably 50% by volume or less, from the viewpoint of further improving the insulation property and thermal conductivity of the composite. The proportion (porosity) is calculated according to the following formula:

$$\text{porosity (\% by volume)} = [1 - (D / 2.28)] \times 100$$

using the bulk density (D; g/cm$^3$) obtained from the volume and mass of the boron nitride sintered body and the theoretical density (2.28 g/cm$^3$) of boron nitride.

A boron nitride sintered body is obtained by molding and then sintering boron nitride powder. That is, in one embodiment, before the impregnation step, a molding step of molding a boron nitride powder to obtain a boron nitride molded body and a sintering step of sintering the boron nitride molded body to obtain a boron nitride sintered body may be performed. More specifically, in the molding step, for example, spherical boron nitride powder obtained by spheroidizing a slurry containing boron nitride powder in a spray dryer or the like can be molded by a press molding method or a cold isostatic pressing (CIP) method. The pressure during molding in the molding step is not particularly limited, but the higher the pressure is, the smaller the average pore diameter of the obtained boron nitride sintered body is, and the lower the pressure is, the larger the average pore diameter of the obtained boron nitride sintered body is.

During molding in the molding step, a sintering aid is preferably added. The sintering aid may be, for example, an alkali metal or alkaline earth metal carbonate such as lithium carbonate, sodium carbonate, calcium carbonate, boric acid, or combinations thereof. The addition amount of the sintering aid with respect to 100 parts by mass of the total of the boron nitride powder and the sintering aid may be, for example, 0.5 parts by mass or more and 25 parts by mass or less, and is preferably 20 parts by mass or less, more preferably 15 parts by mass or less, further preferably 10 parts by mass or less, and particularly preferably 5 parts by mass or less, from the viewpoint of suitably obtaining a boron nitride sintered body having the above-described average pore diameter.

In the sintering step, the boron nitride molded body obtained in the molding step is sintered. The sintering temperature may be, for example, 1600 °C or higher and 2200 °C or lower. The sintering time may be, for example, 1 hour or more, and may be 30 hours or less. The atmosphere during sintering may be, for example, an inert gas atmosphere such as nitrogen, helium, or argon.

The resin composition contains at least a resin. Examples of the resin include epoxy resin, silicone resin, cyanate resin, silicone rubber, acrylic resin, phenol resin, melamine resin, urea resin, unsaturated polyester, fluororesin, polyimide, polyamideimide, polyetherimide, polybutylene terephthalate, polyethylene terephthalate, polyphenylene ether, polyphenylene sulfide, wholly aromatic polyester, polysulfone, liquid crystal polymer, polyethersulfone, polycarbonate, maleimide resin, maleimide-modified resin, ABS (acrylonitrile-butadiene-styrene) resin, AAS (acrylonitrile-acrylic rubber-styrene) resin, AES (acrylonitrile-ethylene-propylene-diene rubber-styrene) resin, polyglycolic acid resin, polyphthalamide, and polyacetal resin.

In one embodiment, the resin preferably includes an epoxy resin from the viewpoint of excellent heat resistance and adhesive strength to a circuit. In this case, the composite is suitably used for an insulating layer of a printed wiring board. In another embodiment, the resin preferably includes a silicone resin from the viewpoint of excellent heat resistance, flexibility, and adhesion to a heat sink or the like. In this case, the composite is suitably used as a thermal interface material.

The resin composition may further contain a curing agent, an inorganic filler, a silane coupling agent, a defoaming agent, a surface modifier, a wetting and dispersing agent, and the like. The resin composition preferably contains one or two or more inorganic fillers (ceramic powder) selected from the group consisting of aluminum oxide, silicon oxide, zinc oxide, silicon nitride, aluminum nitride and aluminum hydroxide from the viewpoint of obtaining a composite having excellent thermal conductivity.

The resin composition may further contain one or two or more solvents. Examples of the solvent include aliphatic alcohols such as ethanol and iso-propanol; ether alcohols such as 2-methoxyethanol, 1-methoxyethanol, 2-ethoxyethanol, 1-ethoxy-2-propanol, 2-butoxyethanol, 2-(2-methoxyethoxy) ethanol, 2-(2-ethoxyethoxy) ethanol, and 2-(2-butoxyethoxy) ethanol; glycol ethers such as ethylene glycol monomethylether and ethylene glycol monobutylether; ketones such as acetone, methylethylketone, methylisobutylketone, and diisobutylketone; and hydrocarbons such as toluene and xylene.

In step S2, the pressure in the impregnation apparatus is reduced to a reduced pressure condition. The pressure P1 under the reduced pressure condition may be, for example, 2000 Pa or less, 1000 Pa or less, 500 Pa or less, 100 Pa or less, or 50 Pa or less.

In step S2, the boron nitride sintered body is immersed in the resin composition under the reduced pressure condition as described above, and is left under the reduced pressure condition for a predetermined time T1 in the immersed state. The predetermined time T1 may be, for example, 10 minutes or more and 720 minutes or less. The temperature of the resin composition at this time may be, for example, 20 °C or more and 150 °C or less.

In step S2, the pressure in the impregnation device is subsequently increased to a pressure condition higher than the pressure P1 of the reduced pressure condition. The pressure P2 under this pressure condition may be, for example, 0.01 MPa or more, 0.05 MPa or more, 0.08 MPa or more, or 0.1 MPa or more, may be 0.5 MPa or less, 0.4 MPa or less, 0.3 MPa or less, or 0.2 MPa or less, and may be atmospheric pressure (0.101325 MPa).

In step S2, the boron nitride sintered body that is immersed in the resin composition is placed under the above-described pressure conditions for a predetermined time T2. The predetermined time T2 may be, for example, 1 minute or more and 60 minutes or less. The temperature of the resin composition at this time may be, for example, 20 °C or more and 150 °C or less.

In step S3, the pressure in the impregnation apparatus is increased to a pressurized condition. The pressure P3 in the pressurized condition may be, for example, 0.2 MPa or more, 0.5 MPa or more, 0.7 MPa or more, 1 MPa or more, 2 MPa or more, 3 MPa or more, 4 MPa or more, or 5 MPa or more, and may be 100 MPa or less, 50 MPa or less, 20 MPa or less, 10 MPa or less, or 5 MPa or less.

In step S3, the boron nitride sintered body that is immersed in the resin composition is placed under the pressurized condition as described above for a predetermined time T3. The predetermined time T3 may be, for example, 5 minutes or more or 15 minutes or more, and may be 720 minutes or less. The temperature of the resin composition at this time may be, for example, 20 °C or more and 150 °C or less.

In step S3, the pressure in the impregnation device is subsequently lowered to a pressure condition lower than the pressure P3 of the pressurized condition. The pressure P4 under this pressure condition may be, for example, 0.01 MPa or more, 0.05 MPa or more, 0.08 MPa or more, or 0.1 MPa or more, and may be 0.5 MPa or less, 0.4 MPa or less, 0.3 MPa or less, or 0.2 MPa or less, or may be atmospheric pressure.

In step S3, the boron nitride sintered body that is immersed in the resin composition is placed under the above-described pressure conditions for a predetermined time T4. The predetermined time T4 may be, for example, 1 minute or more and 60 minutes or less. The temperature of the resin composition at this time may be, for example, 20 °C or more and 150 °C or less.

In the impregnation step described above, step S3 is repeatedly performed a plurality of times. The number of times of performing step S3 may be 2 times or more, 4 times or more, 5 times or more, 6 times or more, 7 times or more, 8 times or more, 9 times or more, or 10 times or more, and may be 20 times or less, 15 times or less, or 13 times or less. By repeating step S3 a plurality of times in this manner, a composite having excellent insulating properties can be obtained. Although the reason is not clear, the present inventors presume that by repeatedly placing the boron nitride sintered body, which is immersed in the resin composition, under a pressurized condition and a pressure condition lower than the pressurized condition, the resin composition suitably flows, and void formation in the composite accompanying curing shrinkage is dispersed, and as a result, the insulation properties are improved.

The production method may further include a step (curing step) of curing the resin in the resin composition filled in the pores of the boron nitride sintered body subsequent to the impregnation step. In the curing step, for example, the boron nitride sintered body and the resin composition filled therein are taken out from the impregnation apparatus, and the resin is cured by heating and/or light irradiation depending on the type of the resin (or the curing agent added as necessary). In the curing step, a part of the resin may be cured (so-called B stage formation), or all of the resins may be cured. The conditions of heating and light irradiation can be appropriately set according to the type of the resin (or the curing agent added as necessary), the desired degree of curing, and the like.

In the above embodiment, the impregnation step includes step S2, but in another embodiment, the impregnation step may not include step S2. From the viewpoint that the boron nitride sintered body can be more suitably impregnated with the resin composition, the impregnation step preferably includes step S2, and step S2 is more preferably repeated a plurality of times in the impregnation step. When step S2 is repeated a plurality of times, the number of times of performing step S2 may be 2 times or more, 4 times or more, 5 times or more, 6 times or more, 7 times or more, 8 times or more, 9 times or more, or 10 times or more, and may be 20 times or less, 15 times or less, or 13 times or less.

The composite obtained by the production method described above inlcudes the porous boron nitride sintered body and the resin filled in the pores of the boron nitride sintered body. The content of the boron nitride sintered body in the composite is not particularly limited, but may be, for example, 30% by volume or more, 40% by volume or more, or 50% by volume or more, and may be 90% by volume or less, 80% by volume or less, 70% by volume or less, or 60% by volume or less, based on the total volume of the composite.

The content of the resin in the composite is not particularly limited, and may be, for example, 20% by volume or more, 25% by volume or more, 30% by volume or more, or 35% by volume or more, and may be 75% by volume or less, 70% by volume or less, 65% by volume or less, 60% by volume or less, or 55% by volume or less, based on the total volume of the composite. The content of the resin in the composite can be measured by the method described in Examples.

The composite may further include other components (including impurities) in addition to the boron nitride sintered body and the resin. The content of the other components may be 10% by volume or less, 5% by volume or less, 3% by volume or less, or 1% by volume or less, based on the total volume of the composite.

**Examples**

Hereinafter, the present invention will be described more specifically based on Examples, but the present invention is not limited to the following Examples.

(Comparative Example 1)

<Fabrication of boron nitride sintered body>

8 parts by mass of amorphous boron nitride powder having an oxygen content of 2.0% and an average particle size of 3.4 $\mu$m, 13 parts by mass of hexagonal boron nitride powder having an oxygen content of 0.3% and an average particle size of 12.5 $\mu$m, 1.1 parts by mass of calcium carbonate ("PC-700", manufactured by Shiraishi Kogyo Co., Ltd.), and 2 parts by mass of boric acid were mixed using a Henschel mixer, and then 76.0 parts by mass of water was added and pulverized in a ball mill for 5 hours to obtain an aqueous slurry. Further, polyvinyl alcohol ("GOHSENOL", manufactured by Nippon Synthetic Chemical Industry Co., Ltd.) was added to the aqueous slurry so as to be 0.5% by mass, and the mixture was heated and stirred at 50 °C until dissolved, and then spheroidized at a drying temperature of 230 °C in a spray dryer. A rotary atomizer was used as a sphering device of the spray dryer. The obtained treated product was filled in a boron nitride container and molded by applying pressure of 20 MPa by cold isostatic pressing (CIP). Subsequently, the molded pruduct was sintered in a batch-type radio frequency oven at atmospheric pressure, a nitrogen flow rate of 5 L/min, and 2050 °C for 10 hours, and then the boron nitride sintered body was taken out from the boron nitride vessel.

<Measurement of average pore diameter>

With respect to the obtained boron nitride sintered body, the pore diameter distribution (horizontal axis: pore diameter, vertical axis: cumulative pore volume) when the pressure was increased from 0.03 atm to 4000 atm was measured using a mercury porosimeter manufactured by Shimadzu Corporation. From the pore size distribution, the average pore diameter was calculated as the pore diameter at which the cumulative pore volume reached 50% of the total pore volume. The results are shown in Table 1.

<Measurement of porosity>

The volume and mass of the obtained boron nitride sintered body were measured, and the bulk density (D; g/cm$^3$) was calculated from the volume and mass. From this bulk density and the theoretical density of boron nitride (2.28 g/cm$^3$), the porosity was calculated according to the following formula:

$$\text{Porosity (\% by volume)} = [1 - (D / 2.28)] \times 100$$

The results are shown in Table 1.

impregnation of resin composition>

The obtained boron nitride sintered body was impregnated with a resin composition by the following procedure.
61 parts by mass of cyanate resin ("TA-CN", manufactured by Mitsubishi Gas Chemical Co., Ltd.), 11 parts by mass of maleimide resin ("BMI-80", manufactured by Kei Kasei Co., Ltd.), and 28 parts by mass of epoxy resins ("HP-4032D", manufactured by DIC Corporation) were mixed at 130 °C for 1 hour to obtain a resin composition.
Subsequently, in a pressure controllable impregnation device, the step S2 in which the boron nitride sintered body that was immersed in the resin composition was placed under a reduced pressure condition P1 (30 Pa) for a predetermined time T1 (120 minutes), and then the boron nitride sintered body that was immersed in the composition was placed under a pressure condition P2 (atmospheric pressure) higher than the reduced pressure condition P1 for a predetermined time T2 (30 minutes), and the step S3 in which the boron nitride sintered body that was immersed in the resin composition was placed under a pressurized condition P3 (0.8 MPa) for a predetermined time T3 (90 minutes), and then the boron nitride sintered body that was immersed in the resin composition was placed under a pressure condition P4 (0.2 MPa) lower than the pressurized condition P3 for a predetermined time T4 (10 minutes) were perfomed. Each of the steps S2 and S3 was performed once.
Thus, a resin-filled boron nitride sintered body (composite) was obtained.

<Measurement of resin content>

The content of the resin in the obtained composite was measured by the following procedure. The results are shown in Table 1.
The content (% by volume) of the resin in the composite was determined by measuring the bulk density of the boron nitride sintered body and the bulk density of the composite shown below.

$$\text{Content of resin in composite (\%)} = ((\text{composite bulk density} - \text{boron nitride sintered body bulk density}) / (\text{composite theoretical density} - \text{boron nitride sintered body bulk density})) \times 100$$

The composite theoretical density was obtained from the following equation.

$$\text{Composite theoretical density} = \text{boron nitride true density} + \text{resin true density} \times (1 - \text{boron nitride sintered body bulk density} / \text{boron nitride true density})$$

The bulk density of the boron nitride sintered body and the composite was determined based on the volume calculated from the length of each side of the boron nitride sintered body or the composite having a regular tetrahedral shape (measured by vernier calipers) and the mass of the boron nitride sintered body or the composite measured by an electronic balance in accordance with the method for measuring density and specific gravity by geometric measurement of JIS Z 8807:2012 (see Section 9 of JIS Z 8807:2012). The true density of the boron nitride sintered body and the resin was determined from the volume and the mass of the boron nitride sintered body and the resin measured using a dry automatic densimeter in accordance with the method for measuring density and specific gravity by the gas replacement method of JIS Z 8807:2012 (see Equations (14) to (17) in Section 11 of JIS Z 8807:2012).

<Evaluation of insulation property>

Each of the obtained composites was cut into a size of 20 mm × 20 mm, and a conductive tape having a size of 16 mm × 16 mm was adhered to the cut composite to obtain a sample for evaluation. Using TOS 5101 manufactured by Kikusui Electronics Co., Ltd., the dielectric breakdown voltage (kV) of the sample for evaluation was measured under a boosting condition of 0.5 kV/30s. The results are shown in Table 1. The higher the dielectric breakdown voltage is, the better the insulating property is.

(Example 1)

A composite was produced, the content of the resin was measured and the insulating properties were evaluated in the same manner as in Comparative Example 1 except that step S3 was repeated 10 times. The results are shown in Table 1.

(Examples 2 to 10)

A boron nitride sintered body was produced in the same manner as in Example 1 except that the blending ratio of the amorphous boron nitride powder, the hexagonal boron nitride powder, the calcium carbonate and the boric acid, and the CIP pressure were changed as shown in Table 1. The average pore diameter and porosity of the obtained boron nitride sintered body were measured in the same manner as in Example 1, and the results are shown in Table 1.

Subsequently, a composite was obtained by impregnating the resin composition in the same manner as in Example 1 except that the pressure conditions in Step S2 and Step S3, the time for which each pressure condition was maintained, and the number of times each step was performed were changed as shown in Table 1. The obtained composite was subjected to the measurement of the resin content and the evaluation of the insulating property in the same manner as in Example 1, and the results were as shown in Table 1.

[0048] [Table 1]

| | | | Comp. Example 1 | Example | | |
|---|---|---|---|---|---|---|
| | | | | 1 | 2 | 3 |
| Production condition of boron nitride sintered body | Blending ratio (parts by mass) | Amorphous boron nitride | 8 | 8 | 8 | 9 |
| | | Hexagonal boron nitride | 13 | 13 | 13 | 13 |
| | | Calcium carbonate | 1.1 | 1.1 | 1.1 | 0.1 |
| | | Boric acid | 2.0 | 2.0 | 1.8 | 0.2 |
| | CIP pressure (MPa) | | 20 | 20 | 10 | 20 |
| Properties of boron nitride sintered body | Average pore diameter (μm) | | 3.5 | 3.5 | 5 | 0.5 |
| | Porosity (% by volume) | | 45 | 45 | 55 | 40 |
| Step S2 | Reduced pressure condition | Pressure P1 (Pa) | 30 | 30 | 30 | 30 |
| | | Time T1 (minutes) | 120 | 120 | 90 | 120 |
| | Higher pressure condition | Pressure P2 (MPa) | Atmos-pheric | Atmos-pheric | 0.5 | 0.6 |
| | | Time T2 (minutes) | 30 | 30 | 10 | 1 |
| | Number of times (times) | | 1 | 1 | 7 | 8 |
| Step S3 | Pressurized condition | Pressure P3 (MPa) | 0.8 | 0.8 | 0.2 | 4 |
| | | Time T3 (minutes) | 90 | 90 | 20 | 6 |
| | Lower pressure condition | Pressure P4 (MPa) | 0.2 | 0.2 | 0.05 | 0.1 |
| | | Time T4 (minutes) | 10 | 10 | 5 | 5 |
| | Number of times (times) | | 1 | 10 | 10 | 11 |
| Properties of composite | Content of resin (% by volume) | | 42 | 42 | 51 | 38 |
| | Insulation property (kV) | | 2.8 | 4.5 | 4.0 | 6.1 |

## [Table 1] (cont.)

| | | | Example | | | |
|---|---|---|---|---|---|---|
| | | | 4 | 5 | 6 | 7 |
| Production condition of boron nitride sintered body | Blending ratio (parts by mass) | Amorphous boron nitride | 8 | 8 | 8 | 8 |
| | | Hexagonal boron nitride | 13 | 13 | 13 | 13 |
| | | Calcium carbonate | 1.1 | 1.1 | 1.1 | 1.1 |
| | | Boric acid | 1.8 | 1.8 | 2.0 | 1.8 |
| | CIP pressure (MPa) | | 15 | 20 | 20 | 20 |
| Properties of boron nitride sintered body | Average pore diameter (μm) | | 4 | 3 | 3.5 | 3 |
| | Porosity (% by volume) | | 50 | 48 | 49 | 48 |
| Step S2 | Reduced pressure condition | Pressure P1 (Pa) | 10 | 2000 | 30 | 10 |
| | | Time T1 (minutes) | 150 | 200 | 10 | 60 |
| | Higher pressure condition | Pressure P2 (MPa) | 0.02 | 0.09 | Atmospheric | 0.1 |
| | | Time T2 (minutes) | 5 | 60 | 20 | 10 |
| | Number of times (times) | | 10 | 3 | 11 | 10 |
| Step S3 | Pressurized condition | Pressure P3 (MPa) | 0.5 | 0.8 | 2 | 4 |
| | | Time T3 (minutes) | 10 | 720 | 120 | 90 |
| | Lower pressure condition | Pressure P4 (MPa) | 0.2 | Atmospheric | Atmospheric | 0.01 |
| | | Time T4 (minutes) | 1 | 20 | 60 | 10 |
| | Number of times (times) | | 7 | 4 | 8 | 9 |
| Properties of composite | Content of resin (% by volume) | | 47 | 45 | 46 | 45 |
| | Insulation property (kV) | | 4.2 | 5.1 | 4.7 | 5.2 |

## [Table 1] (cont.)

| | | | Example | | | |
|---|---|---|---|---|---|---|
| | | | 8 | 9 | 10 | 11 |
| Production condition of boron nitride sintered body | Blending ratio (parts by mass) | Amorphous boron nitride | 8 | 9 | 8 | 8 |
| | | Hexagonal boron nitride | 13 | 13 | 13 | 13 |
| | | Calcium carbonate | 1.1 | 0.1 | 1.1 | 1.1 |
| | | Boric acid | 2.0 | 0.1 | 2.0 | 2.0 |
| | CIP pressure (MPa) | | 25 | 20 | 20 | 20 |
| Properties of boron nitride sintered body | Average pore diameter (µm) | | 3 | 1 | 3.5 | 3.5 |
| | Porosity (% by volume) | | 55 | 45 | 49 | 49 |
| Step S2 | Reduced pressure condition | Pressure P1 (Pa) | 30 | 30 | 40 | 35 |
| | | Time T1 (minutes) | 720 | 90 | 150 | 160 |
| | Higher pressure condition | Pressure P2 (MPa) | Atmospheric | 0.01 | 0.4 | 0.2 |
| | | Time T2 (minutes) | 5 | 20 | 30 | 15 |
| | Number of times (times) | | 2 | 10 | 10 | 12 |
| Step S3 | Pressurized condition | Pressure P3 (MPa) | 1 | 3 | 0.5 | 0.7 |
| | | Time T3 (minutes) | 300 | 300 | 200 | 150 |
| | Lower pressure condition | Pressure P4 (MPa) | 0.4 | 0.2 | 0.2 | 0.2 |
| | | Time T4 (minutes) | 1 | 10 | 5 | 5 |
| | Number of times (times) | | 10 | 5 | 9 | 5 |
| Properties of composite | Content of resin (% by volume) | | 51 | 43 | 46 | 46 |
| | Insulation property (kV) | | 5.0 | 6.0 | 4.5 | 4.9 |

## Claims

1. A method for producing a composite, comprising a step of placing a porous boron nitride sintered body immersed in a resin composition under a pressurized condition and then placing the boron nitride sintered body immersed in the resin composition under a pressure condition lower than the pressurized condition, wherein the step is repeated a plurality of times.

2. The method for producing a composite according to claim 1, further comprising, before the step, a step of placing the boron nitride sintered body immersed in the resin composition under a reduced pressure condition and then placing the boron nitride sintered body immersed in the resin composition under a pressure condition higher than the reduced pressure condition.

3. The method for producing a composite according to claim 1 or 2, wherein the boron nitride sintered body has an average pore diameter of 3.5 $\mu$m or less, wherein the average pore diameter is defined as the pore diameter at which the cumulative pore volume reaches 50% of the total pore volume in the pore diameter distribution measured using a mercury porosimeter.

**Patentansprüche**

1. Verfahren zur Herstellung eines Verbundstoffs, umfassend den Schritt des Setzens eines porösen Bornitrid-Sinterkörpers, der in eine Harzzusammensetzung eingetaucht ist, unter einen Druckzustand, und dann Setzen des Bornitrid-Sinterkörpers, der in die Harzzusammensetzung eingetaucht ist, unter einen Druckzustand, der niedriger als der druckbeaufschlagte Zustand ist, wobei der Schritt mehrere Male wiederholt wird.

2. Verfahren zur Herstellung eines Verbundstoffs gemäß Anspruch 1, ferner umfassend, vor dem Schritt, einen Schritt des Setzens des Bornitrid-Sinterkörpers, der in die Harzzusammensetzung eingetaucht ist, unter einen reduzierten Druckzustand, und dann Setzen des Bornitrid-Sinterkörpers, der in die Harzzusammensetzung eingetaucht ist, unter einen Druckzustand, der höher ist als der reduzierte Druckzustand.

3. Verfahren zur Herstellung eines Verbundstoffs gemäß Anspruch 1 oder 2, wobei der Bornitrid-Sinterkörper einen durchschnittlichen Porendurchmesser von 3,5 $\mu$m oder weniger aufweist, wobei der durchschnittliche Porendurchmesser als der Porendurchmesser definiert ist, bei dem das kumulative Porenvolumen 50% des Gesamtporenvolumens in der Porendurchmesserverteilung erreicht, gemessen unter Verwendung eines Quecksilberporosimeters.

**Revendications**

1. Procédé de production d'un composite, comprenant une étape consistant à placer un corps fritté poreux en nitrure de bore immergé dans une composition de résine dans une condition pressurisée et ensuite à placer le corps fritté en nitrure de bore immergé dans la composition de résine dans une condition de pression inférieure à la condition pressurisée, dans lequel l'étape est répétée plusieurs fois.

2. Procédé de production d'un composite selon la revendication 1, comprenant en outre, avant l'étape, une étape consistant à placer le corps fritté en nitrure de bore immergé dans la composition de résine dans une condition de pression réduite et ensuite à placer le corps fritté en nitrure de bore immergé dans la composition de résine dans une condition de pression supérieure à la condition de pression réduite.

3. Procédé de production d'un composite selon la revendication 1 ou 2, dans lequel le corps fritté en nitrure de bore présente un diamètre moyen de pore de 3,5 $\mu$m ou moins, dans lequel le diamètre moyen de pore est défini comme étant le diamètre de pore auquel le volume de pore cumulé atteint 50 % du volume de pore total dans la répartition du diamètre de pore mesuré au moyen d'un porosimètre à mercure.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2014196496 A
- JP 2015124122 A
- WO 2014196496 A1